(19) Europäisches Patentamt
European Patent Office
Office européen des brevets

(11) **EP 0 992 886 B1**

(12) **EUROPÄISCHE PATENTSCHRIFT**

(45) Veröffentlichungstag und Bekanntmachung des Hinweises auf die Patenterteilung:
**17.12.2008 Patentblatt 2008/51**

(51) Int Cl.:
*G06F 7/544* *(2006.01)*   *G01R 19/02* *(2006.01)*
*G01R 19/25* *(2006.01)*

(21) Anmeldenummer: **99113742.3**

(22) Anmeldetag: **14.07.1999**

(54) **Verfahren und Vorrichtung zum Bestimmen der Energie eines Signals**

Method and device for determining the energy of a signal

Procédé et dispositif de détermination de l'énergie d'un signal

(84) Benannte Vertragsstaaten:
**DE FR GB IT NL**

(30) Priorität: **10.10.1998 DE 19846787**

(43) Veröffentlichungstag der Anmeldung:
**12.04.2000 Patentblatt 2000/15**

(73) Patentinhaber: **Micronas GmbH**
**79108 Freiburg i. Br. (DE)**

(72) Erfinder: **Vierthaler, Matthias**
**79108 Freiburg (DE)**

(74) Vertreter: **Patentanwälte**
**Westphal, Mussgnug & Partner**
**Am Riettor 5**
**78048 Villingen-Schwenningen (DE)**

(56) Entgegenhaltungen:
**EP-A- 0 862 060**   **DE-C- 19 613 736**
**US-A- 4 757 467**

**Beschreibung**

Die Erfindung bezieht sich auf Verfahren und Vorrichtungen zum Bestimmen der Energie eines Signals gemäß den Oberbegriffen der Verfahrensansprüche 1 und 8 sowie der Vorrichtungsansprüche 4 und 9. Eine solche Vorrichtung und ein solches Verfahren ist aus US 4,757,467

Aus der Theorie zur Verarbeitung elektrischer Signale ist ein idealer Exponentially weighted Root Mean Square (ERMS)-Detektor zum Ermitteln der Energie y eines analogen Signals s(u) bekannt. Er ermittelt die Energie durch eine sequentielle Abwicklung von drei Verfahrensschritten: Quadrieren des Signals, Integrieren des quadrierten Signals und Radizieren des integrierten Signals. Diese Verfahrensschritte spiegeln sich auch in folgender Funktionsgleichung

$$\dot{y}(s(u),t) = \sqrt{\frac{1}{T} \int_{-\infty}^{t} s^2(u) \cdot e^{-\frac{(t-u)}{T}} \, du} \quad ,$$

wieder, die das Funktionsprinzip des idealen analogen Detektors beschreibt. Der Detektor ermittelt die Energie y des Signals s.(u) als dessen exponentiell mit einer Zeitkonstanten T gewichteten Effektivwert als Funktion der Zeit t.

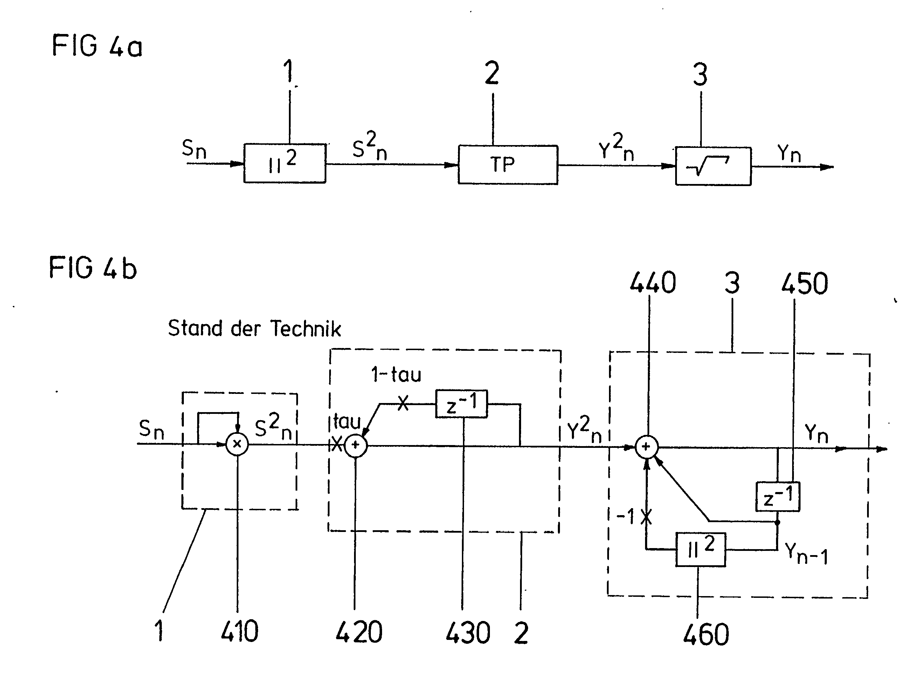

Die in der Praxis eingesetzten herkömmlichen digitalen ERMS-Detektoren empfangen an ihrem Eingang ein digitales Signal $s_n$, um an ihrem Ausgang ein digitales Energiesignal $y_n$ auszugeben, dessen Amplitudenwierte die Energie des Signals $s_n$ repräsentieren. Sie basieren auf den aus der Theorie bekannten Verfahrensschritten. Zur Umsetzung dieser Verfahrensschritte sind sie i.d.R., wie in Fig. 4a gezeigt, als Reihenschaltung eines Quadrierers 1, eines Tiefpaßfilters 2 und eines Radizierers 3 ausgebildet.

Fig. 4b zeigt eine mögliche digitale Implementierung für eine solche Reihenschaltung. Demnach wird der Quadrierer 1 aus einem ersten Multiplizierer 410 gebildet, der das digitale Signal $s_n$ mit sich selbst multipliziert, um an seinem Ausgang das quadrierte Signal $s^2_n$ bereitzustellen. Das quadrierte Signal wird nachfolgend, gewichtet mit einem Faktor tau, als Eingangssignal dem digitalen Tiefpaß 2 zugeführt.

Innerhalb des Tiefpasses 2 wird das Eingangssignal als erster Summand an einen Addierer 420 weitergeleitet, der an seinem Ausgang das gesuchte Energiesignal, allerdings quadriert als $y^2_n$, ausgibt. Als zweiter Summand wird dem Addierer 420 sein, über einen Zustandsspeicher 430 rückgekoppeltes und mit dem Faktor 1-tau gewichtetes Ausgangssignal $y^2$ zugeführt.

Nachfolgend wird das quadrierte Energiesignal $y^2_n$ durch den nachgeschalteten Radizierer 3 radiziert. Der Radizierer 3 umfaßt einen zweiten Addierer 440, der das quadrierte Energiesignal $y^2_n$ empfängt und an seinem Ausgang das gesuchte Energiesignal $y_n$ ausgibt. Zur Berechnung des Energiesignals $y_n$ addiert der Addierer 440 das quadrierte Energiesignal mit zwei weiteren Signalen. Dies ist zum einen das über einen zweiten Zustandsspeicher 450 von seinem eigenen Ausgang rückgekoppelte Energiesignal $y_{n-1}$ und zum anderen ein Signal - $y^2_{n-1}$, das durch Quadrierung und Negierung aus dem rückgekoppelten Energiesignal $y_{n-1}$ gewonnen wird.

Die aufgezeigte herkömmliche Berechnung des Energiesignals $y_n$ ist mit folgenden Nachteilen behaftet:

Durch die Quadrierung des Signals $s_n$ wird dessen Dynamikbereich stark vergrößert. Eine Speicherung des quadrierten Signals ist daher nur in einem Speicher mit einer sehr großen Wortbreite möglich.

Die bei herkömmlichen Radizierern verwendeten Quadratwurzelroutinen konvergieren langsam, oftmals in Abhängigkeit der Größe der Amplitude ihres Eingangssignals. Sie sind deshalb für eine Verwendung in Systemen, die ein schnelles Konvergenzverhalten des Detektors erfordern, wie z.B. Compander-Expander-Systeme, ungeeignet.

Es ist die Aufgabe der Erfindung, gattungsgemäße Verfahren und Vorrichtungen zum Bestimmen der Energie eines Signals so weiterzubilden, daß sie ein schnelleres Konvergenzverhalten zeigen und einen verringerten Rechenaufwand sowie weniger Speicherplatz erfordern.

Diese Aufgabe wird durch die in den Verfahrensansprüchen 1 und 8 beanspruchten Verfahrensschritte sowie durch die in den Vorrichtungsansprüchen 4 und 9 beanspruchten Merkmale gelöst. Weitere vorteilhafte Ausgestaltungen der Erfindung sind Gegenstand der Unteransprüche.

Gemäß einer ersten Ausführungsform des erfindungsgemäßen Verfahrens, wie es in dem unabhängigen Verfahrensanspruch 1 dargestellt ist, wird die Aufgabe insbesondere dadurch gelöst, daß die Berechnung eines Energiesignals $y_n$, dessen Amplitudenwerte die Energie eines Signals $s_n$ repräsentieren, gemäß der Gleichung

$$y_n = \frac{tau \cdot s^2_n}{2 \cdot y_{n-1}} + (1 - \frac{tau}{2}) \cdot y_{n-1} \quad , \qquad\qquad (1)$$

mit

tau :    einem vorgegebenem Parameter, wobei tau größer 0 und Kleiner 1 ist, und
n :      dem Taktschritt

erfolgt, wobei in der Gleichung 1 die Verfahrensschritte Quadrieren, Tiefpaßfiltern und Radizieren zusammengefaßt sind.

Der Parameter Tau bestimmt Zeitkonstanten für die exponentielle Gewichtung. Er steht mit der Zeitkonstanten T in der analogen Formel (S. 1) näherungsweise in folgendem Zusammenhang:

$$tau = \left| 0{,}5 \cdot \frac{(1 - e^{\frac{i}{T \cdot fs}})}{(0{,}5 - e^{\frac{i}{T \cdot fs}})} \right|$$

wobei gilt:

i=Sqrt(-1)
fs= Abtastfrequenz des digitalen Systems.

Beispiel:
mit fs=48kHz und T=20ms ergibt sich tau zu ca. 0,00104.

Die Erklärungen zu den Parametern tau und n gelten gleichermaßen für alle nachfolgenden Gleichungen in der Beschreibung.

Bei dem nach Gleichung 1 durchgeführten Verfahren zeigt der integrierte Verfahrensschritt des Radizierens ein quadratisches Konvergenzverhalten, was sich sehr vorteilhaft auf das dynamische Verhalten des gesamten Verfahrens auswirkt.

Weiterhin ist der Verfahrensschritt des Radizierens in dem Schritt des Tiefpaßfilterns integriert, wodurch der Rechenaufwand verringert wird.

Für die Durchführung des Verfahrens ist es nicht mehr erforderlich, das quadrierte Signal $s^2_n$ mit seinem großen Dynamikbereich zu speichern; vielmehr ist es ausreichend, die ermittelten Amplitudenwerte des Energiesignals $y_n$ zu speichern, die aufgrund der erfolgten Radizierung einen gegenüber dem Dynamikbereich des quadrierten Signals $s^2_n$ erheblich verringerten Wertebereich aufweisen. Aus diesem Grund kann bei dem erfindungsgemäßen Verfahren ein Speicher mit relativ kleiner Wortbreite eingesetzt werden.

Gemäß einer vorteilhaften Weiterbildung des Verfahrens umfaßt die Berechnung des ersten Summanden in der Gleichung 1 die Schritte 'Multiplizieren des Signals $s_n$ mit einem Hilfssignal tau/ $2y_{n-1}$ zu einem Produktsignal' und 'Multiplizieren des Produktsignals mit dem Signal $s_n$' oder alternativ die Schritte 'Quadrieren des Signals $s_n$' und 'Multiplizieren des quadrierten Signal $s^2_n$ mit dem Hilfssignal tau/ $2y_{n-1}$'. Je nach gewählter Implementierung des Verfahrens kann die eine oder die andere Alternative zu einer Verringerung des Rechen- und Speicheraufwandes beitragen.

Die aufgeführten Vorteile der ersten Ausführungsform des erfindungsgemäßen Verfahrens gelten analog auch für eine zugehörige Vorrichtung.

Für die zugehörige erfindungsgemäße Vorrichtung ist es vorteilhaft, wenn diese einen Inverter zum Empfangen des Energiesignals $y_n$ und zum Ausgeben eines invertierten Signals $b_n = \dfrac{tau}{2y_n}$ aufweist, der so ausgebildet ist, daß er die durch die Gleichung

$$b_n = b_{n-1} \cdot 2 \frac{k}{tau} \cdot \left( \frac{(1+k) \cdot tau}{2k} - (b_{n-1} \cdot y_n) \right), \qquad (2)$$

mit

k :    einer Konstanten zwischen vorzugsweise 0,5 und 1,

vorgegebene Verknüpfung zwischen dem invertierten Signal $b_n$ und dem Energiesignal $y_n$ realisiert. Das Konvergenzverhalten des Inverters läßt sich durch die Wahl der Konstanten k beeinflussen; auf diese Weise kann auch das quadratische Konvergenzverhalten der gesamten Vorrichtung optimiert werden. (Anmerkung: die Erklärung zu der Konstanten k gilt gleichermaßen für alle nachfolgenden Gleichungen in der Beschreibung.)

Gemäß einer zweiten Ausführungsform des erfindungsgemäßen Verfahrens, wie es in dem unabhängigen Verfahrensanspruch 8 dargestellt ist, wird die Aufgabe insbesondere dadurch gelöst, daß die Berechnung des Energiesignals $y_n$ gemäß der Gleichung

$$y_n = y_{n-1} + \frac{tau}{2y_{n-1}}(s^2{}_n - y^2{}_{n-1}) \qquad\qquad (3)$$

erfolgt, wobei in der Gleichung 3 die Verfahrensschritte Quadrieren, Tiefpaßfiltern und Radizieren zusammengefaßt sind.

Bei dem nach Gleichung 3 durchgeführten Verfahren zeigt der Verfahrensschritt des Radizierens ein quadratisches Konvergenzverhalten, was sich sehr vorteilhaft auf das dynamische Verhalten des gesamten Verfahrens auswirkt.

Weiterhin ist der Verfahrensschritt des Tiefpaßfilterns in dem Schritt des Radizierens integriert, wodurch der Rechenaufwand verringert wird.

Für die Durchführung des Verfahrens ist es nicht mehr erforderlich, das quadrierte Signal $s^2{}_n$ mit seinem großen Dynamikbereich zu speichern; vielmehr ist es ausreichend, den aktuell ermittelten Wert für das Energiesignal $y_n$ zu speichern, der aufgrund der erfolgten Radizierung einen gegenüber dem Dynamikbereich des quadrierten Signals $s^2{}_n$ erheblich verringerten Wertebereich aufweist. Aus diesem Grund kann bei dem erfindungsgemäßen Verfahren ein Speicher mit wesentlich verkleinerter Wortbreite eingesetzt werden.

Die aufgeführten Vorteile der zweiten Ausführungsform des erfindungsgemäßen Verfahrens gelten analog auch für eine zugehörige Vorrichtung.

Für die Vorrichtung gemäß der zweiten Ausführungsform ist es aus den genannten Gründen ebenfalls vorteilhaft, wenn sie den oben beschriebenen Inverter aufweist.

Der Beschreibung sind folgende Figuren beigefügt, wobei

Figur 1a    eine Implementierung eines erfindungsgemäßen Detektors gemäß einer ersten Ausführungsform;

Figur 1b    eine alternative Ausgestaltung des Detektors nach Figur 1a;

Figur 2    eine Implementierung eines erfindungsgemäßen Detektors gemäß einer zweiten Ausführungsform;

Figur 3    eine Implementierung eines erfindungsgemäßen Inverters;

Figur 4a    ein Blockschaltbild eines herkömmlichen Detektors; und

Figur 4b    eine Implementierung des herkömmlichen Detektors aus Figur 4a zeigt.

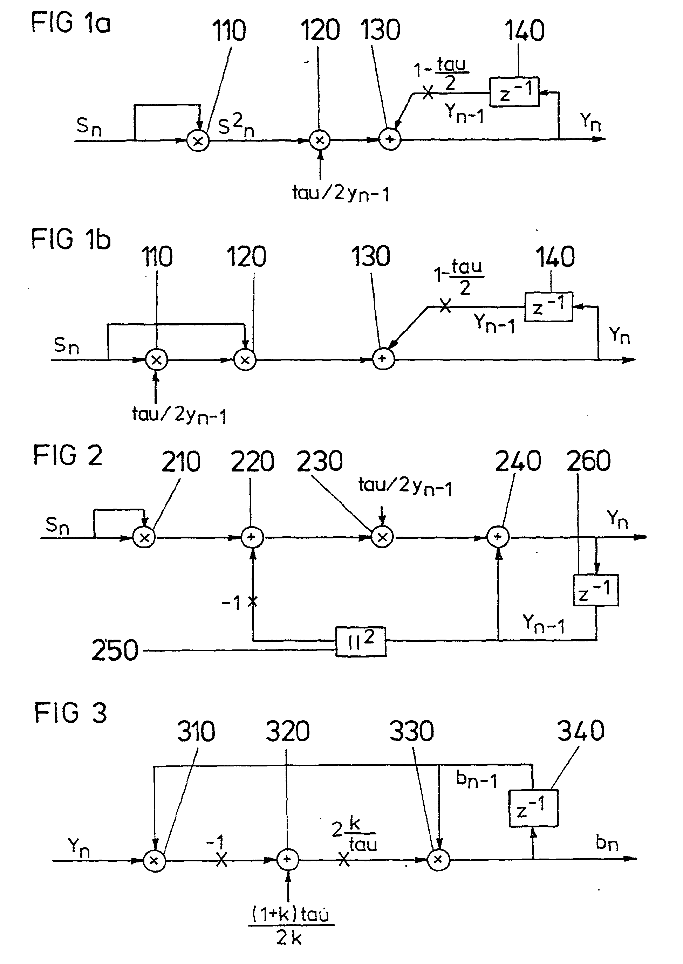

Es folgt eine detaillierte Beschreibung der beiden bevorzugten Ausführungsformen der Erfindung unter Bezugnahme auf die Figuren 1a, 1b, 2 und 3.

Die in Figur 1a gezeigte erste Ausführungsform eines erfindungsgemäßen Detektors berechnet ein Energiesignal $y_n$, dessen Amplitudenwerte die Energie eines Signals $s_n$ repräsentieren, nach der folgenden Gleichung:

$$y_n = \frac{tau \cdot s^2{}_n}{2 \cdot y_{n-1}} + (1 - \frac{tau}{2}) \cdot y_{n-1} \qquad\qquad (1).$$

Zur schaltungstechnischen oder softwaremäßigen Realisierung der Gleichung 1 weist der Detektor einen ersten 110 und zweiten 120 Multiplizierer, einen Addierer 130 und einen Zustandsspeicher 140 auf.

Das Eingangssignal $s_n$ wird zwei Eingängen des ersten Multiplizierers 110 zugeführt, so daß an dessen Ausgang das quadrierte Eingangssignal $s^2_n$ zur Verfügung steht. Das quadrierte Signal wird nachfolgend an den zweiten Multiplizierer 120 weitergeleitet, der es mit einem Hilfssignal $tau/2y_{n-1}$ multipliziert. Ein von dem zweiten Multiplizierer 120 berechnetes Produktsignal wird einem ersten Eingang des Addierers 130 zugeführt, der an seinem Ausgang das zu ermittelnde Energiesignal $y_n$ bereitstellt. Zur Berechnung des Energiesignals $y_n$ wird dieses über den Zustandsspeicher 140, gewichtet mit einem Faktor $1-tau/2$, auf einen zweiten Eingang des Addierers 130 rückgekoppelt.

Mit der so verschalteten ersten Ausführungsform des erfindungsgemäßen Detektors wird ein Tiefpaßfilter realisiert, in das ein Radizierer integriert ist.

Eine alternative, in Fig. 1b gezeigte, Ausgestaltung der ersten Ausführungsform des Detektors unterscheidet sich von der Ausgestaltung gemäß Figur 1a lediglich in der Verschaltung der beiden Multiplizierer 110 und 120. Gemäß der alternativen Ausgestaltung nach Fig. 1b multipliziert der Multiplizierer 110 das Signal $s_n$ zunächst mit dem Hilfssignal $tau/2y_{n-1}$. Das Produktsignal am Ausgang des ersten Multiplizierers wird dann dem Multiplizierer 120 zugeführt, der das Produktsignal mit dem Signal $s_n$ multipliziert.

Bei den alternativen Ausgestaltungen des Detektors gemäß den Figuren 1a und 1b sind die Produktsignale an den Ausgängen der zweiten Multiplizierer 120 jeweils identisch.

Gemäß der in Figur 2 gezeigten zweiten Ausführungsform des erfindungsgemäßen Detektors wird ein Energiesignal $y_n$, dessen Amplitudenwerte die Energie eines Signals $s_n$ repräsentieren, nach der folgenden Gleichung berechnet:

$$y_n = y_{n-1} + \frac{tau}{2y_{n-1}}(s^2_n - y^2_{n-1}) \qquad (3).$$

Zur schaltungstechnischen oder softwaremäßigen Realisierung der Gleichung 3 weist der Detektor gemäß der zweiten Ausführungsform einen ersten 210 und zweiten 230 Multiplizierer, einen ersten 220 und zweiten 240 Addierer, einen Zustandsspeicher 260 und einen Quadrierer 250 auf.

Den beiden Eingängen des ersten Multiplizierers 210 wird das Signals $s_n$ zugeführt, so daß am Ausgang des ersten Multiplizierers das quadrierte Signal $s^2_n$ bereitgestellt wird. Das quadrierte Signal wird auf einen ersten Eingang des ersten Addierers 220 gegeben, dessen Ausgangssignal dem zweiten Multiplizierer 230 zugeführt wird. Der zweite Multiplizier 230 multipliziert das Ausgangssignal des Addierers 220 mit dem Hilfssignal $tau/2y_{n-1}$ und gibt das ermittelte Produktsignal an einen ersten Eingang des zweiten Addierers 240 aus, der an seinem Ausgang das zu erzeugende Energiesignal $y_n$ bereitstellt. Das Ausgangssignal des Addierers 240 wird über den Zustandsspeicher 260 auf einen zweiten Eingang des zweiten Addierers 240 zurückgekoppelt. Außerdem wird das Ausgangssignal $y_{n-1}$ des Zustandsspeichers 260 über den nachgeschalteten Quadrierer 250 nach erfolgter Negierung auf den zweiten Eingang des ersten Addierers 220 zurückgekoppelt.

Mit der so verschalteten zweiten Ausführungsform des erfindungsgemäßen Detektors wird ein Radizierer realisiert, in den ein Tiefpaßfilter integriert ist.

Figur 3 zeigt die Implementierung eines Inverters zum Invertieren des Energiesignals $y_n$ in ein Signal $b_n = tau/2y_n$. Die Invertierung erfolgt erfindungsgemäß nach folgender Gleichung:

$$b_n = b_{n-1} \cdot 2\frac{k}{tau} \cdot (\frac{(1+k) \cdot tau}{2k} - (b_{n-1} \cdot y_n)) \qquad (2).$$

Für eine schaltungstechnische oder softwaremäßige Realisierung der Gleichung 2 weist der Inverter einen ersten 310 und zweiten 330 Multiplizierer, einen Addierer 320 und einen Zustandsspeicher 340 auf.

Der erste Multiplizierer 310 multipliziert das empfangene Energiesignal $y_n$ mit dem über den Zustandsspeicher 340 rückgekoppelten Ausgangssignal $b_{n-1}$ des Inverters. Das Ausgangssignal des ersten Multiplizierers 310 wird negiert dem Addierer 320 zugeführt, der es mit dem Summanden $(1+k)*tau/2k$ addiert. Das Summensignal am Ausgang des Addierers 320 wird mit dem Faktor $2k/tau$ gewichtet und an den zweiten Multiplizierer 330 weitergeleitet, der es mit dem Ausgangssignal $b_{n-1}$ des Zustandsspeichers 340 multipliziert. Am Ausgang des zweiten Multiplizierers 330 wird das Ausgangssignal $b_n$ des Inverters bereitgestellt, das gleichzeitig dem Zustandsspeicher 340 als Eingangssignal zugeführt wird.

Für alle Varianten des ERMS Detektors gilt:

Das Verfahren liefert ungenaue Ergebnisse, falls $y_n$ sprunghaft stark ansteigt, so dass gilt: $y_n > c \cdot y_{n-1}$. Hierbei ist c eine Konstante, die je nach gewünschter Genauigkeit gewählt werden kann. Eine gute Genauigkeit ergibt sich bei c<1,5.

Um in diesem Fall die Genauigkeit zu verbessern, können zusätzlich folgende Iterationen durchgeführt werden. Dies ist nur bei sprunghafter Änderung der Signalenergie und großen Anforderungen an die Genauigkeit erforderlich. Dies führt zu folgender Modifikation:

$$y_{n,m} = tau \cdot \frac{s^2_n}{2 y_{n,m-1}} + (1 - \frac{tau}{2}) \cdot y_{n-1}$$

bzw.

$$y_{n,m} = y_{n-1} + \frac{tau}{2 y_{n,m-1}} (s^2_n - y^2_{n-1})$$

wobei gilt:

m= zusätzlicher Iterationsindex.

Die Iteration sind so lange durchführen, bis gilt:

$$\frac{1}{c} < \left| \frac{y_{n,m}}{y_{n,m-1}} \right| < c$$

In der Regel reichen auch bei starken Sprüngen der Eingangssignale 2-3 Iterationen aus.

Bezugszeichenliste

| | |
|---|---|
| Energiesignal | $y_n$ |
| Signal | $s_n$ |
| invertiertes Signal | $b_n$ |

Stand der Technik

| | |
|---|---|
| Quadrierer | 1 |
| Tiefpaß | 2 |
| Radizierer | 3 |
| erster Multiplizierer | 410 |
| zweiter Addierer | 440 |
| Addierer | 420 |
| erster Zustandsspeicher | 430 |
| zweiter Zustandsspeicher | 450 |
| Quadrierer | 460 |

| erste Ausführungsform des Detektors | |
| --- | --- |
| erster Multiplizierer | 110 |
| zweiter Multiplizierer | 120 |
| Addierer | 130 |
| Zustandsspeicher | 140 |

| zweite Ausführungsform des Detektors | |
| --- | --- |
| erster Multiplizierer | 210 |
| zweiter Multiplizierer | 230 |
| Addierer | 220/240 |
| Zustandsspeicher | 260 |
| Quadrierer | 250 |

Inverter

| erster Multiplizierer | 310 |
| --- | --- |
| zweiter Multiplizierer | 330 |
| Addierer | 320 |
| Zustandsspeicher | 340 |

**Patentansprüche**

1. Verfahren zum Bestimmen der Energie eines Signals ($s_n$), mit den Schritten:

a) Quadrieren des Signals ($s_n$);
b) Tiefpaßfiltern des quadrierten Signals ($s^2_n$); und
c) Radizieren des tiefpaßgefilterten Signals aus Schritt b) zum Erzeugen eines Energiesignals ($y_n$), dessen Amplitudenwerte die Energie des Signals ($s_n$) repräsentieren;

**dadurch gekennzeichnet, daß**
das Energiesignal ($y_n$) gemäß der Gleichung

$$y_n = \frac{tau \cdot s^2_n}{2 \cdot y_{n-1}} + (1 - \frac{tau}{2}) \cdot y_{n-1} \quad , \qquad (1)$$

mit

tau : einem vorgegebenem Parameter, wobei tau größer 0 und kleiner 1 ist, und
n : dem Taktschritt,

aus dem Signal ($s_n$) berechnet wird, wobei in der Gleichung (1) die Schritte a) - c) zusammengefaßt sind und der Schritt c) des Radizierens in den Schritt b) des Tiefpaßfilterns integriert ist.

2. Verfahren nach Anspruch 1, **dadurch gekennzeichnet, daß** die Berechnung des ersten summandens in der Gleichung (1) folgende Schritte umfaßt:

- Multiplizieren des Signals ($s_n$) mit einem Hilfssignal tau/$2y_{n-1}$ zu einem Produktsignal; und
- Multiplizieren des Produktsignals mit dem Signal ($s_n$).

**3.** Verfahren nach Anspruch 1, **dadurch gekennzeichnet, daß** die Berechnung des ersten Summandens in der Gleichung (1) folgende Schritte umfaßt:

- Quadrieren des Signals ($s_n$); und
- Multiplizieren des quadrierten Signals ($s^2_n$) mit dem Hilfssignal tau/$2y_{n-1}$.

**4.** Vorrichtung zum Bestimmen der Energie eines Signals ($s_n$), mit:

- einem Quadrierer zum Empfangen des Signals ($s_n$) und zum Ausgeben des quadrierten Signals ($s^2_n$);
- einem Tiefpaßfilter zum Tiefpaßfiltern des quadrierten Signals ($s^2_n$); und
- einem Radizierer zum Radizieren des tiefpaßgefilterten quadrierten Signals aus Schritt b) und zum Erzeugen eines Energiesignals ($y_n$), dessen Amplitudenwerte die Energie des Signals ($s_n$) repräsentieren;

**dadurch gekennzeichnet, daß**
die Vorrichtung so ausgebildet ist, daß sie die durch die Gleichung

$$y_n = \frac{tau \cdot s^2_n}{2 \cdot y_{n-1}} + (1 - \frac{tau}{2}) \cdot y_{n-1} \quad , \tag{1}$$

mit

tau : einem vorgegebenem Parameter, wobei tau größer 0 und kleiner 1 ist, und
n : dem Taktschritt,

vorgegebene Verknüpfung zwischen dem von ihr empfangenen Signal ($s_n$) und dem von ihr ausgegebenen Energiesignal ($y_n$) realisiert wobei die Verknüpfung den Quadrierer, das Tiefpaßfilter und den Radizierer in der Weise nachbildet, daß der Radizierer in das Tiefpaßfilter integriert ist.

**5.** Vorrichtung nach Anspruch 4, **gekennzeichnet durch**
einen ersten Multiplizierer (110), welcher das empfangene Signal ($s_n$) mit einem Hilfssignal tau/$2y_{n-1}$ multipliziert und an seinem Ausgang ein Produktsignal bereitstellt; und
einen zweiten Multiplizierer (120), welcher das Produktsignal mit dem Signal ($s_n$) multipliziert.

**6.** Vorrichtung nach Anspruch 4, **gekennzeichnet durch**
einen ersten Multiplizierer (110), welcher das empfangene Signal ($s_n$) quadriert; und
einen zweiten Multiplizierer (120), welcher das quadrierte Signal mit einem Hilfssignal tau/ $2y_{n-1}$ multipliziert.

**7.** Vorrichtung nach einem der Ansprüche 4-6, **dadurch gekennzeichnet, daß** sie einen Inverter zum Empfangen des Energiesignals ($y_n$) und zum Ausgeben eines invertierten Signals $b_n = \frac{tau}{2y_n}$ aufweist, der so ausgebildet ist, daß er die durch die Gleichung

$$b_n = b_{n-1} \cdot 2 \frac{k}{tau} \cdot (\frac{(1+k) \cdot tau}{2k} - (b_{n-1} \cdot y_n)) \quad , \tag{2}$$

mit

k : einer Konstanten zwischen 0,5 und 1,
tau : einem vorgegebenem Parameter, wobei tau größer 0 und kleiner 1 ist, und
n : dem Taktschritt,

vorgegebene Verknüpfung zwischen dem Signal ($b_n$) und dem Energiesignal ($y_n$) realisiert.

8. Verfahren zum Bestimmen der Energie eines Signals ($s_n$), mit den Schritten:

a) Quadrieren des Signals ($s_n$);
b) Tiefpaßfiltern des quadrierten Signals ($s^2_n$); und
c) Radizieren des tiefpaßgefilterten Signals aus Schritt b) zum Erzeugen eines Energiesignals ($y_n$), dessen Amplitudenwerte die Energie des Signals ($s_n$) repräsentieren;

**dadurch gekennzeichnet, daß**
das Energiesignal ($y_n$) gemäß der Gleichung

$$y_n = y_{n-1} + \frac{tau}{2y_{n-1}}(s^2_n - y^2_{n-1}) \quad , \qquad (3)$$

mit

tau : einem vorgegebenem Parameter, wobei tau größer 0 und kleiner 1 ist, und
n : dem Taktschritt,

aus dem Signal ($s_n$) berechnet wird, wobei in der Gleichung (2) die Schritte a)- c) zusammengefaßt sind und der Schritt b) des Tiefpaßfilterns in den Schritt c) des Radizierens integriert ist

9. Vorrichtung zum Bestimmen der Energie eines Signals ($s_n$), mit:

- einem Quadrierer zum Empfangen des Signals ($s_n$) und zum Ausgeben des quadrierten Signals ($s^2_n$);
- einem Tiefpaßfilter zum Tiefpaßfiltern des quadrierten Signals ($s^2_n$) ; und
- einem Radizierer zum Radizieren des tiefpaßgefilterten quadrierten Signals und zum Erzeugen eines Energiesignals ($y_n$), dessen Amplitudenwerte die Energie des Signals ($s_n$) repräsentieren;

**dadurch gekennzeichnet, daß**
die Vorrichtung so ausgebildet ist, daß sie die durch die Gleichung

$$y_n = y_{n-1} + \frac{tau}{2y_{n-1}}(s^2_n - y^2_{n-1}), \qquad (3)$$

mit

tau : einem vorgegebenem Parameter, wobei tau größer 0 und kleiner 1 ist, und
n : dem Zeittakt,

vorgegebene Verknüpfung zwischen dem von ihr empfangenen Signal ($s_n$) und dem von ihr ausgegebenen Energiesignal ($y_n$) realisiert, wobei die Verknüpfung den Quadrierer, das Tiefpaßfilter und den Radizierer in der Weise nachbildet, daß das Tiefpaßfilter in dem Radizierer integriert ist.

10. Vorrichtung nach Anspruch 9, **dadurch gekennzeichnet, daß** sie einen Inverter zum Empfangen des Energiesignals ($y_n$) und Ausgeben des Signals $b_n = \frac{tau}{2y_n}$ aufweist, der so ausgebildet ist, daß er die durch die Gleichung

$$b_n = b_{n-1} \cdot 2\frac{k}{tau} \cdot (\frac{(1+k) \cdot tau}{2k} - (b_{n-1} \cdot y_n)) \quad , \qquad (2)$$

mit

k : einer Konstanten zwischen 0,5 und 1,
tau : einem vorgegebenem Parameter, wobei tau größer 0 und kleiner 1 ist, und
n : dem Zeittakt für die Berechnung der Signale,

vorgegebene Verknüpfung zwischen dem Signal $b_n$ und dem Energiesignal ($y_n$) realisiert.

**Claims**

1. A method for determining the energy of a signal ($s_n$), having the steps of:

   a) squaring the signal ($s_n$);
   b) low-pass filtering the squared signal ($s^2_n$); and
   c) finding the square root of the low-pass-filtered signal from step b) to generate an energy signal ($y_n$), the amplitude values of which represent the energy of the signal ($s_n$);

   **characterised in that**
   the energy signal ($y_n$) is calculated from the signal ($s_n$) in accordance with the equation

$$y_n = \frac{tau \cdot s^2_n}{2 \cdot y_{n-1}} + (1 - \frac{tau}{2}) \cdot y_{n-1} \qquad (1)$$

   where

   tau is a predetermined parameter, with tau being greater than 0 and less than 1, and
   n is the clock cycle,

   whereby steps a) and c) are incorporated into equation (1) and step c) of finding the square root is integrated into step b) of the low-pass filtering.

2. A method according to Claim 1,
   **characterised in that** the calculation of the first summand in equation (1) includes the following steps:

   - multiplying the signal ($s_n$) by an auxiliary signal $tau/2y_{n-1}$ to form a product signal; and
   - multiplying the product signal by the signal ($s_n$).

3. A method according to Claim 1,
   **characterised in that** the calculation of the first summand in equation (1) includes the following steps :

   - squaring the signal ($s_n$); and
   - multiplying the squared signal ($s^2_n$) by the auxiliary signal $tau/2y_{n-1}$.

4. A device for determining the energy of a signal ($s_n$), having:

   - a squaring element for receiving the signal ($s_n$) and for outputting the squared signal ($s^2_n$);
   - a low-pass filter for low-pass filtering the squared signal ($s^2_n$) ; and
   - a rooter circuit for finding the square root of the low-pass-filtered squared signal from step b) and for generating an energy signal ($y_n$), the amplitude values of which represent the energy of the signal ($s_n$) ;

   **characterised in that**
   the device is designed so that it performs the operation between the signal ($s_n$) received thereby and the energy signal ($y_n$) outputted thereby by the equation

$$y_n = \frac{tau \cdot s^2_n}{2 \cdot y_{n-1}} + (1 - \frac{tau}{2}) \cdot y_{n-1} \quad , \qquad (1)$$

where

tau is a predetermined parameter, with tau being greater than 0 and less than 1, and
n is the clock cycle,

the operation simulating the squaring element, the low-pass filter and the rooter circuit so that the rooter circuit is integrated in the low-pass filter.

5. A device according to Claim 4,
**characterised by**
a first multiplier (110), which multiplies the received signal ($s_n$) by an auxiliary signal $tau/2y_{n-1}$ and provides a product signal at its output; and
a second multiplier (120), which multiplies the product signal by the signal ($s_n$).

6. A device according to Claim 4,
**characterised by** a first multiplier (110), which squares
the received signal ($s_n$) ; and
a second multiplier (120), which multiplies the squared signal by an auxiliary signal $tau/2y_{n-1}$.

7. A device according to one of Claims 4 to 6,
**characterised in that** it comprises an inverter for receiving the energy signal ($y_n$) and for outputting an inverted signal

$$b_n = \frac{tau}{2y_n}$$

which is designed so that it performs the operation between the signal ($b_n$) and the energy signal ($y_n$) that is predetermined by the equation

$$b_n = b_{n-1} \cdot 2 \frac{k}{tau} \cdot (\frac{(1+k) \cdot tau}{2k} - (b_{n-1} \cdot y_n)) \quad , \qquad (2)$$

where

k is a constant between 0.5 and 1,
tau is a predetermined parameter, with tau being greater than 0 and less than 1, and
n is the clock cycle.

8. A method for determining the energy of a signal ($s_n$), having the steps of:

a) squaring the signal ($s_n$);
b) low-pass filtering the squared signal ($s^2_n$); and
c) finding the square root of the low-pass-filtered signal from step b) to generate an energy signal ($y_n$), the amplitude values of which represent the energy of the signal ($s_n$);

**characterised in that**
the energy signal ($y_n$) is calculated from the signal ($s_n$) in accordance with the equation

$$y_n = y_{n-1} + \frac{tau}{2y_{n-1}}(s^2_n - y^2_{n-1})$$

(3)

where

tau is a predetermined parameter, with tau being greater than 0 and less than 1, and
n is the clock cycle,

in equation (2) steps a) - c) being combined and step b) of the low-pass filtering being integrated into step c) of finding the square root.

9. A device for determining the energy of a signal ($s_n$), having:

- a squaring element for receiving the signal ($s_n$) and for outputting the squared signal ($s^2_n$) ;
- a low-pass filter for low-pass filtering the squared signal ($s^2_n$) ; and
- a rooter circuit for finding the square root of the low-pass-filtered, squared signal and for generating an energy signal ($y_n$), the amplitude values of which represent the energy of the signal ($s_n$);

**characterised in that** the device is designed so that it performs the operation between the signal ($s_n$) received thereby and the energy signal ($y_n$) outputted thereby, which operation is predetermined by the equation

$$y_n = y_{n-1} + \frac{tau}{2y_{n-1}}(s^2_n - y^2_{n-1}),$$

(3)

where

tau is a predetermined parameter, tau being greater than 0 and less than 1, and
n is the time pulse,

the operation simulating the squaring element, the low-pass filter and the rooter circuit so that the low-pass filter is integrated in the rooter circuit.

10. A device according to Claim 9,
**characterised in that** it comprises an inverter for receiving the energy signal ($y_n$) and for outputting the signal

$$b_n = \frac{tau}{2y_n},$$

which inverter is designed so that it performs the operation between the signal $b_n$ and the energy signal ($y_n$), which operation is predetermined by the equation

$$b_n = b_{n-1} \cdot 2\frac{k}{tau} \cdot (\frac{(1+k)\cdot tau}{2k} - (b_{n-1} \cdot y_n)),$$

(2)

where

k is a constant between 0.5 and 1,
tau is a predetermined parameter, with tau being greater than 0 and less than 1, and
n is the time pulse for calculating the signals.

**Revendications**

1. Procédé pour déterminer l'énergie d'un signal ($s_n$) comprenant les étapes suivantes :

   a) élévation au carré du signal ($s_n$),
   b) filtrage par un filtre passe-bas du signal élevé au carré ($s^2_n$), et
   c) extraction de la racine carrée du signal filtré par le filtre passe-bas selon l'étape b) pour former un signal d'énergie ($y_n$) dont les valeurs d'amplitude représentent l'énergie du signal ($s_n$),

   **caractérisé en ce que**
   le signal d'énergie ($y_n$) se calcule à partir du signal ($s_n$) selon l'équation suivante :

$$y_n = \frac{tau \cdot s^2_n}{2 \cdot y_{n-1}} + (1 - \frac{tau}{2}) \cdot y_{n-1} \quad , \qquad (1)$$

   dans laquelle,

   tau : paramètre prédéfini ; tau étant supérieur à 0 et inférieur à 1 ; et
   n : pas de la cadence,

   dans l'équation (1) on regroupe les étapes a) - c), et l'étape c) de l'extraction de la racine carrée est intégrée dans l'étape b) du filtrage passe-bas.

2. Procédé selon la revendication 1,
   **caractérisé en ce que**
   le calcul du premier terme de la somme de l'équation (1) comprend les étapes suivantes :

   - multiplication du signal ($s_n$) par le signal auxiliaire tau/$2y_{n-1}$. pour former un signal de produit, et
   - multiplication du signal de produit par le signal ($s_n$).

3. Procédé selon la revendication 1,
   **caractérisé en ce que**
   le calcul du premier terme de la somme de l'équation (1) comprend les étapes suivantes :

   - mise au carré du signal ($s_n$), et
   - multiplication du signal élevé au carré ($s^2_n$) par le signal auxiliaire tau/ $2y_{n-1}$.

4. Dispositif pour déterminer l'énergie d'un signal ($s_n$) comprenant :

   - un élément de mise au carré pour recevoir le signal ($s_n$) et pour fournir un signal élevé au carré ($s^2n$),
   - un filtre passe-bas pour assurer le filtrage passe-bas du signal élevé au carré ($s^2_n$), et
   - un extracteur de racine carrée pour extraire la racine carrée du signal élevé au carré, filtré par un filtre passe-bas selon l'étape b) et pour générer un signal d'énergie ($y_n$) dont les valeurs d'amplitude représentent l'énergie du signal ($s_n$),

   **caractérisé en ce que**
   le dispositif est réalisé pour obtenir une combinaison prédéfinie entre le signal reçu ($s_n$) et le signal d'énergie émis ($y_n$) selon l'équation suivante :

$$y_n = \frac{tau \cdot s^2_n}{2 \cdot y_{n-1}} + (1 - \frac{tau}{2}) \cdot y_{n-1} \quad , \qquad (1)$$

   dans laquelle

   tau : paramètre prédéfini; tau étant supérieur à 0 et inférieur à 1 ; et
   n : pas de la cadence,

la combinaison de l'élément de mise au carré, du filtre passe-bas et de l'élément d'extraction de racine carrée étant formée de façon à intégrer l'élément d'extraction de racine carrée dans le filtre passe-bas.

5. Dispositif selon la revendication 4,
**caractérisé en ce qu'**

- un premier multiplicateur (110) qui multiplie le signal reçu ($s_n$) par un signal auxiliaire tau/2$y_{n-1}$ fournit un signal de produit à sa sortie, et
- un second multiplicateur (120) qui multiplie le signal de produit par le signal ($s_n$).

6. Dispositif selon la revendication 4,
**caractérisé par**

- un premier multiplicateur (110) qui élève le signal reçu ($s_n$) au carré, et
- un second multiplicateur (120) qui multiplie le signal élevé au carré par un signal auxiliaire tau/2$y_{n-1}$.

7. Dispositif selon les revendications 4 à 6,
**caractérisé en ce qu'**

il comporte un inverseur pour recevoir le signal d'énergie ($y_n$) et pour émettre un signal inversé $b_n = \frac{tau}{2y_n}$ , réalisé pour obtenir une combinaison prédéfinie entre le signal ($b_n$) et le signal d'énergie ($y_n$) en application de l'équation :

$$b_n = b_{n-1} \cdot 2 \frac{k}{tau} \cdot \left( \frac{(1+k) \cdot tau}{2k} - (b_{n-1} \cdot y_n) \right), \qquad (2)$$

dans laquelle

k : constante comprise entre 0,5 et 1,
tau : paramètre prédéfinie ; tau étant supérieur à 0 et inférieur à 1, et
n : pas de la cadence.

8. Procédé pour déterminer l'énergie d'un signal ($s_n$) comprenant les étapes suivantes :

a) élévation au carré du signal ($s_n$),
b) filtrage par un filtre passe-bas du signal élevé au carré ($s^2_n$), et
c) extraction de la racine carrée du signal filtré par un filtre passe-bas selon l'étape b) pour générer un signal d'énergie ($y_n$) dont les valeurs d'amplitude représentent l'énergie du signal ($s_n$),

**caractérisé en ce que**
le signal d'énergie ($y_n$) se calcule à partir du signal ($s_n$) en application de l'équation suivante :

$$y_n = y_{n-1} + \frac{tau}{2y_{n-1}}(s^2_n - y^2_{n-1}), \qquad (3)$$

dans laquelle

tau : paramètre prédéfini, tau étant supérieur à 0 et inférieur à 1, et
n : pas de la cadence,

et dans l'équation (2) on regroupe les étapes a) - c), et l'étape b) du filtrage passe-bas est intégrée dans l'étape c) de l'extraction de la racine carrée.

9. Dispositif pour déterminer l'énergie d'un signal ($s_n$) comprenant :

- un élément d'élévation au carré pour recevoir le signal ($s_n$) et fournir un signal élevé au carré ($s^2_n$),
- un filtre passe-bas pour un filtrage passe-bas du signal élevé au carré ($s^2_n$), et
- un élément d'extraction de la racine carrée pour extraire la racine carrée du signal élevé au carré, filtré par un filtre passe-bas et pour générer un signal d'énergie ($y_n$) pour les valeurs d'amplitude représente l'énergie du signal ($s_n$),

**caractérisé en ce que**

le dispositif est réalisé pour obtenir, une combinaison prédéfinie entre le signal reçu ($s_n$) par le dispositif et le signal d'énergie ($y_n$) qu'il fournit par application de l'équation :

$$y_n = y_{n-1} + \frac{tau}{2y_{n-1}}(s^2_n - y^2_{n-1}),\qquad(3)$$

dans laquelle

tau : paramètre prédéfini, tau étant supérieur à 0 et inférieur à 1, et
n : pas de la cadence,

la combinaison de l'élément d'élévation au carré, du filtre passe-bas et de l'élément d'extraction de racine étant réalisée de façon à intégrer le filtre passe-bas dans l'élément d'extraction de la racine carrée.

**10.** Dispositif selon la revendication 9,
**caractérisé en ce qu'**

il comporte un inverseur pour recevoir le signal d'énergie ($y_n$) et émettre le signal $b_n = \dfrac{tau}{2y_n}$ , tel qu'il réalise une combinaison prédéfinie entre le signal ($b_n$) et le signal d'énergie ($y_n$) par l'équation :

$$b_n = b_{n-1} \cdot 2\frac{k}{tau} \cdot \left( \frac{(1+k)\cdot tau}{2k} - (b_{n-1}\cdot y_n) \right),\qquad(2)$$

dans laquelle

k : constante comprise entre 0,5 et 1,
tau : paramètre prédéfini ; tau étant supérieur à 0 et inférieur à 1, et
n : pas de la cadence.

FIG 1a

$$1-\frac{tau}{2}$$

$S_n$ — 110 — $S^2_n$ — 120 — 130 — 140 — $z^{-1}$ — $Y_{n-1}$ — $Y_n$

$tau/2 y_{n-1}$

FIG 1b

$$1-\frac{tau}{2}$$

$S_n$ — 110 — 120 — 130 — 140 — $z^{-1}$ — $Y_{n-1}$ — $Y_n$

$tau/2 y_{n-1}$

FIG 2

$tau/2 y_{n-1}$

$S_n$ — 210 — 220 — 230 — 240 — 260 — $Y_n$ — $z^{-1}$

$-1$

$250$ — $\| \|^2$ — $Y_{n-1}$

FIG 3

$$\frac{(1+k) tau}{2k}$$

$Y_n$ — 310 — $-1$ — 320 — $2\frac{k}{tau}$ — 330 — $b_{n-1}$ — 340 — $z^{-1}$ — $b_n$

FIG 4a

FIG 4b

Stand der Technik

EP 0 992 886 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4757467 A